# EUROPEAN PATENT APPLICATION

(11) **EP 4 557 608 A1**
(43) Date of publication of application: **21.05.2025**
(21) Application number: 23853028.1
(22) Date of filing: 10.08.2023
(51) Int. Cl.: H03F 1/02, H03F 3/193, H03F 3/60

(54) **POWER AMPLIFIER AND ELECTRONIC DEVICE COMPRISING SAME**

(30) Priority: 12.08.2022 KR 20220101490
(71) Applicant: Samsung Electronics Co., Ltd., Suwon-si, Gyeonggi-do 16677 (KR)
(72) Inventor: OH, Sungjae, Suwon-si, Gyeonggi-do 16677 (KR); LEE, Juho, Suwon-si, Gyeonggi-do 16677 (KR); LEE, Daeyoung, Suwon-si, Gyeonggi-do 16677 (KR)
(74) Representative: HGF
(86) International application number: PCT/KR2023/011839
(87) International publication number: WO 2024/035160

(57) **Abstract**

The present disclosure relates to a 5G or 6G communication system for supporting a higher data transmission rate. A power amplifier according to the present disclosure comprises: a signal processor; a control circuit electrically connected to the signal processor; a divider electrically connected to the signal processor and the control circuit; a first amplifier electrically connected to the divider; a second amplifier electrically connected to the control circuit and the divider; and a combiner electrically connected to the control circuit, the first amplifier and the second amplifier.

## Description

### [Technical Field]

The present disclosure relates to an electronic device, and more specifically, to a power amplifier and an electronic device including the same.

### [Background Art]

5G mobile communication technologies define broad frequency bands such that high transmission rates and new services are possible, and can be implemented not only in "Sub 6 GHz" bands such as 3.5 GHz, but also in ultra-high frequency bands, "Above 6 GHz" bands referred to as mmWave such as 28 GHz and 39 GHz. In addition, it has been considered to implement 6G mobile communication technologies (referred to as Beyond 5G systems) in terahertz bands (for example, 95 GHz to 3 THz bands) in order to accomplish transmission rates fifty times faster than 5G mobile communication technologies and ultra-low latencies one-tenth of 5G mobile communication technologies.

At the beginning of the development of 5G mobile communication technologies, in order to support services and to satisfy performance requirements in connection with enhanced mobile broadband (eMBB), ultra reliable low latency communications (URLLC), and massive machine-type communications (mMTC), there has been ongoing standardization regarding beamforming and massive MIMO for mitigating radio-wave path loss and increasing radio-wave transmission distances in mmWave, supporting numerologies (for example, operating multiple subcarrier spacings) for efficiently utilizing mmWave resources and dynamic operation of slot formats, initial access technologies for supporting multi-beam transmission and broadbands, definition and operation of bandwidth part (BWP), new channel coding methods such as a low density parity check (LDPC) code for large amount of data transmission and a polar code for highly reliable transmission of control information, L2 preprocessing, and network slicing for providing a dedicated network specialized to a specific service.

Currently, there are ongoing discussions regarding improvement and performance enhancement of initial 5G mobile communication technologies in view of services to be supported by 5G mobile communication technologies, and there has been physical layer standardization regarding technologies such as V2X (Vehicle-to-everything) for aiding driving determination by autonomous vehicles based on information regarding positions and states of vehicles transmitted by the vehicles and for enhancing user convenience, NR-U (New Radio Unlicensed) aimed at system operations conforming to various regulation-related requirements in unlicensed bands, NR UE Power Saving, Non-Terrestrial Network (NTN) which is UE-satellite direct communication for providing coverage in an area in which communication with terrestrial networks is unavailable, and positioning.

Moreover, there has been ongoing standardization in air interface architecture/protocol regarding technologies such as Industrial Internet of Things (IIoT) for supporting new services through interworking and convergence with other industries, integrated access and backhaul (IAB) for providing a node for network service area expansion by supporting a wireless backhaul link and an access link in an integrated manner, mobility enhancement including conditional handover and dual active protocol stack (DAPS) handover, and two-step random access for simplifying random access procedures (2-step RACH for NR). There also has been ongoing standardization in system architecture/service regarding a 5G baseline architecture (for example, service based architecture or service based interface) for combining network functions virtualization (NFV) and software-defined networking (SDN) technologies, and mobile edge computing (MEC) for receiving services based on UE positions.

As 5G mobile communication systems are commercialized, connected devices that have been exponentially increasing will be connected to communication networks, and it is accordingly expected that enhanced functions and performances of 5G mobile communication systems and integrated operations of connected devices will be necessary. To this end, new research is scheduled in connection with extended reality (XR) for efficiently supporting augmented reality (AR), VR virtual reality (VR), mixed reality (MR) and the like, 5G performance improvement and complexity reduction by utilizing artificial intelligence (AI) and machine learning (ML), AI service support, metaverse service support, and drone communication.

Furthermore, such development of 5G mobile communication systems will serve as a basis for developing not only new waveforms for providing coverage in terahertz bands of 6G mobile communication technologies, multi-antenna transmission technologies such as full dimensional MIMO (FD-MIMO), array antennas and large-scale antennas, metamaterial-based lenses and antennas for improving coverage of terahertz band signals, high-dimensional space multiplexing technology using orbital angular momentum (OAM), and reconfigurable intelligent surface (RIS), but also full-duplex technology for increasing frequency efficiency of 6G mobile communication technologies and improving system networks, AI-based communication technology for implementing system optimization by utilizing satellites and artificial intelligence (AI) from the design stage and internalizing end-to-end AI support functions, and next-generation distributed computing technology for implementing services at levels of complexity exceeding the limit of UE operation capability by utilizing ultra-high-performance communication and computing resources.

### [Disclosure]

### [Technical Problem]

The present disclosure is directed to providing a power amplifier that is capable of reducing power consumption. The present disclosure is directed to providing a power amplifier that is capable of reducing power consumption for radio frequency integrated circuits (RFICs) for beamforming. The present disclosure is directed to providing a power amplifier that is capable of addressing the heating issues of RF modules for the D-band. The present disclosure is directed to providing a power amplifier with reduced power consumption and no loss in gain.

### [Technical Solution]

A power amplifier according to the present disclosure includes: a signal processor; a control circuit electrically connected to the signal processor; a divider electrically connected to the signal processor and the control circuit; a first amplifier electrically connected to the divider; a second amplifier electrically connected to the control circuit and the divider; and a combiner electrically connected to the control circuit, the first amplifier, and the second amplifier.

The signal processor may output a first input signal and a threshold signal to the control circuit. The control circuit may generate a first control signal or a second control signal based on the first input signal and the threshold signal.

The signal processor may output the first input signal to the divider. The control circuit may output the first control signal to the divider. The divider may output the first input signal to the first amplifier based on the first control signal.

The first power amplifier may output the first input signal received from the divider to the combiner.

The signal processor may output the first input signal to the divider. The control circuit may output the second control signal to the divider. The divider may separate the first input signal into a second input signal and a third input signal based on the second control signal. The divider may output the second input signal to the first amplifier. The divider may output the third input signal to the second amplifier.

The first power amplifier may output the second input signal received from the divider to the combiner. The second power amplifier may output the third input signal received from the divider to the combiner.

The combiner may include a first transmission line, a second transmission line, and a first switch. The first transmission line may be electrically connected to the first amplifier. The second transmission line may be electrically connected to the second amplifier.

The first switch may be electrically connected to the second amplifier and the second transmission line.

The first switch may be electrically connected to the second amplifier.

The divider includes a first coil, a second coil electromagnetically coupled to the first coil, a third coil electrically connected to the first coil, a fourth coil electromagnetically coupled to the third coil, and a second switch electrically connected to the first coil and the third coil. The second switch may be turned on or off based on a control signal output from the control signal. The divider, based on the second switch being turned on or off, may output the first input signal received from the signal processor to the first amplifier, or separate the first input signal into a second input signal and a third input signal to output the second input signal to the first amplifier and output the third input signal to the second amplifier.

An electronic device according to the present disclosure, may include a transceiver including a power amplifier, a controller configured to control the transceiver, and a memory storing instructions executed by the controller.

### [Advantageous Effects]

The power amplifier and the electronic device including the same, according to the present disclosure, can reduce power consumption. The power amplifier and the electronic device including the same, according to the present disclosure, can reduce the power consumption of radio frequency integrated circuits (RFICs) for beamforming. The power amplifier and the electronic device including the same, according to the present disclosure, can address the heating issues of RF modules for the D-band. The power amplifier and the electronic device including the same, according to the present disclosure, can reduce power consumption without any loss in gain.

### [Description of Drawings]

FIG. 1 is a conceptual view illustrating a power amplifier 10 according to an embodiment of the present disclosure.
FIG. 2 is a conceptual view illustrating the power amplifier 10 according to another embodiment of the present disclosure.
FIG. 3 is a graph illustrating the relationship between a RF input (RF in) signal and an input voltage (Vin) according to a low power mode control signal and a high power mode control signal of the power amplifier 10 according to the present disclosure.
FIG. 4 is a graph illustrating the relationship between the input voltage (Vin) and efficiency according to the low power mode and high power mode of the power amplifier 10 according to the present disclosure.
FIG. 5 is a conceptual view illustrating a divider of the power amplifier 10 according to an embodiment of the present disclosure.
FIG. 6 is a conceptual view illustrating a divider of the power amplifier 10 according to another embodiment of the present disclosure.
FIG. 7 is a conceptual view illustrating a control circuit 200 of the power amplifier 10 according to the present disclosure.
FIG. 8 is a graph illustrating the power dissipation according to the low power mode and high power mode of the power amplifier 10 according to the present disclosure.
FIG. 9 is a graph illustrating a gain according to the low power mode and high power mode of the power amplifier 10 according to the present disclosure.
FIG. 10 is a graph illustrating power added efficiency (PAE) according to the low power mode and high power mode of the power amplifier 10 according to the present disclosure.
FIG. 11 is a conceptual view illustrating the power amplifier 10 according to yet another embodiment of the present disclosure.
FIG. 12 is a graph illustrating the relationship between the input voltage (Vin) and efficiency according to the low power mode and high power mode of the power amplifier 10 according to yet another embodiment of the present disclosure.
FIG. 13 is a block diagram illustrating an electronic device 1 including the power amplifier 10 according to the present disclosure.
FIG. 14 is a flowchart illustrating the operation sequence of the power amplifier 10 or the electronic device 1 including the power amplifier 10 according to an embodiment of the present disclosure.
FIG. 15 is a flowchart illustrating the operation sequence of the power amplifier 10 or the electronic device 1 including the power amplifier 10 according to another embodiment of the present disclosure.

### [Mode for Disclosure]

Hereinafter, embodiments of the present disclosure will be described with reference to the accompanying drawings. In this case, it should be noted that the same constituent elements will be designated by the same reference numerals in the accompanying drawings. In addition, detailed descriptions of publicly-known functions and configurations, which may obscure the subject matter of the present disclosure, will be omitted.

When describing the embodiments in the present specification, a description of technical contents, which are well known in the technical field to which the present disclosure pertains but are not directly related to the present disclosure, will be omitted. This is to more clearly describe the subject matter of the present invention without obscuring the subject matter by omitting any unnecessary description.

Similarly, in the accompanying drawings, some constituent elements are illustrated in an exaggerated or schematic form or are omitted. In addition, a size of each constituent element does not entirely reflect an actual size. Like reference numerals designate like or corresponding constituent elements in the drawings.

Advantages and features of the present disclosure and methods of achieving the advantages and features will be clear with reference to exemplary embodiments described in detail below together with the accompanying drawings. However, the present disclosure is not limited to the exemplary embodiments disclosed herein but will be implemented in various forms. The exemplary embodiments of the present disclosure are provided so that the present disclosure is completely disclosed, and a person with ordinary skill in the art can fully understand the scope of the present disclosure. The present disclosure will be defined only by the scope of the appended claims. Throughout the specification, the same reference numerals denote the same constituent elements.

In this case, it will be understood that each block of processing flowchart illustrations and combination of flowchart illustrations may be performed by computer program instructions. These computer program instructions may be incorporated into a processor of a general purpose computer, a special purpose computer, or other programmable data processing equipment, such that the instructions executed by the processor of the computer or other programmable data processing equipment create means for performing the functions described in the flowchart block(s). These computer program instructions may also be stored in a computer usable or computer-readable memory that can direct a computer or other programmable data processing apparatus to function in a particular manner, such that the instructions stored in the computer usable or computer-readable memory produce an article of manufacture including instruction means that performs the function described in the flowchart block(s). The computer program instructions may also be loaded onto a computer or other programmable data processing apparatus to cause a series of operational steps to be performed on the computer or other programmable apparatus to produce a computer implemented process such that the instructions that execute on the computer or other programmable apparatus may provide steps for implementing the functions described in the flowchart block(s).

In addition, each block may represent a module, segment, or portion of code that includes one or more executable instructions for executing a specified logical function(s). Additionally, it should be noted that it is possible for the functions mentioned in the blocks to occur out of order in some alternative execution examples. For example, two blocks illustrated in succession may in fact be performed substantially simultaneously, or the blocks may sometimes be performed in a reverse order depending on the corresponding function.

In this case, the term such as a "unit" or a "portion" used in the present embodiments means a software constituent element or a hardware constituent element such as FPGA or ASIC, and the "unit" or the "portion" performs a certain role. However, the term 'unit', 'part', or 'portion' is not limited to software or hardware. The term 'unit', 'part', or 'portion' may be configured to be in an addressable storage medium or configured to reproduce one or more processors. Thus, as an example, the term 'unit', 'part', or 'portion' includes constituent elements such as software constituent elements, object-oriented software constituent elements, class constituent elements, and task components, processes, functions, properties, procedures, subroutines, segments of program codes, drivers, firmware, microcode, circuitry, data, database, data structures, tables, arrays, and variables. The functions provided in the constituent elements and the term, 'units', 'parts', or 'portions' may be combined into a smaller number of constituent elements, 'units', 'parts', and 'portions' and/or divided into additional constituent elements, 'units', 'parts', and 'portions'. In addition, the constituent elements and 'units', 'parts', and 'portions' may be implemented to execute one or more CPUs within a device or secure multimedia card.

Hereinafter, a base station, as an entity responsible for performing resource allocation of a terminal, may be at least one of a Node B, a BS (base station), an eNB (eNode B), a gNB (gNode B), a radio access unit, a base station controller, or a node on the network. A terminal may include user equipment (UE), a mobile station (MS), a cellular phone, a smartphone, a computer, or a multimedia system capable of performing communication functions. In addition, the embodiments of the present disclosure described below may be applied to other communication systems with a similar technical background or channel types as those of the present disclosure. In addition, the embodiments of the present disclosure may be applied to other communication systems with some modifications without substantially departing from the scope of the present disclosure as determined by those skilled in the art.

The terms used to identify connection nodes (node), terms referring to network entities or network functions (NFs), terms referring to messages, terms referring to interfaces between network entities, and terms referring to various identification information in the following description are provided for illustrative purposes for the convenience of description. Therefore, the present disclosure is not limited to the terms described below, and other terms referring to subjects with equivalent technical meanings may be used.

Hereinafter, for the convenience of the description, some terms and names defined in the 3rd generation partnership project (3GPP) long term evolution specification may be used. However, the present disclosure is not limited by the terms and names, and may be equally applied to systems following other specifications.

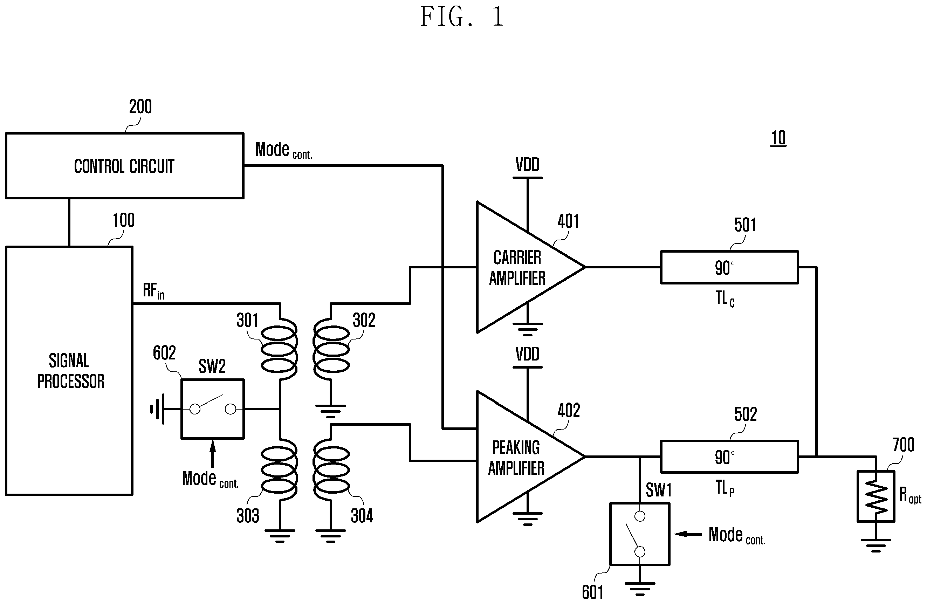

FIG. 1 is a conceptual view illustrating a power amplifier 10 according to an embodiment of the present disclosure.

With reference to FIG. 1, the power amplifier 10 may include a signal processor 100, a control circuit 200, a first coil 301, a second coil 302, a third coil 303, a fourth coil 304, a first amplifier (Carrier Amp) 401, a second amplifier (Peaking Amp) 402, a first transmission line (TLc) 501, a second transmission line (TLp) 502, a first switch (SW1) 601, a second switch (SW2) 602, and a resistor (Ropt) 700.

The signal processor 100 may be electrically connected to the control circuit 200 and the first coil 301. For example, the first port of the signal processor 100 may be electrically connected to a first port of the control circuit 200. The second port of the signal processor 100 may be electrically connected to one end of the first coil 301. The signal processor 100 may output an RF input signal (RF in) to the first coil 301 through the second port.

The control circuit 200 may be electrically connected to the signal processor 100 and the second amplifier 402. For example, the first port of the control circuit 200 may be electrically connected to the second port of the signal processor 100. The second port of the control circuit 200 may be electrically connected to the fifth port of the second amplifier 402. The control circuit 200 may output a control signal (Mode cont) to the second amplifier 402 through the second port.

The control circuit 200 may be electrically connected to the first switch 601 and the second switch 602. For example, the second port of the control circuit 200 may be electrically connected to the third port of the first switch 601. The control circuit 200 may output a control signal (Mode cont) to the first switch 601 through the second port. The second port of the control circuit 200 may be electrically connected to the third port of the second switch 602. The control circuit 200 may output a control signal (Mode cont) to the second switch 602 through the second port.

The first coil 301 may be electrically connected to the signal processor 100, the third coil 303, and the second switch 602. For example, one end of the first coil 301 may be electrically connected to the second port of the signal processor 100. The other end of the first coil 301 may be electrically connected to one end of the third coil 303 and the first port of the second switch 602. The first coil 301 may be electromagnetically coupled to the second coil 302.

The second coil 302 may be electrically connected to the first amplifier 401. For example, one end of the second coil 302 may be electrically connected to the first port of the first amplifier 401. The other end of the second coil 302 may be grounded. The second coil 302 may be electromagnetically coupled to the first coil 301.

The third coil 303 may be electrically connected to the first coil 301 and the second switch 602. For example, one end of the third coil 303 may be electrically connected to the other end of the first coil 301 and the first port of the second switch 602. The other end of the third coil 303 may be grounded. The third coil 303 may be electromagnetically coupled to the fourth coil 304.

The fourth coil 304 may be electrically connected to the second amplifier 402. For example, one end of the fourth coil 304 may be electrically connected to the second port of the second amplifier 402. The other end of the fourth coil 304 may be grounded. The fourth coil 304 may be electromagnetically coupled to the third coil 303.

The first amplifier 401 may be electrically connected to the second coil 302 and the first transmission line 501. For example, the first port of the first amplifier 401 may be electrically connected to one end of the second coil 302. The second port of the first amplifier 401 may be electrically connected to one end of the first transmission line 501. The third port of the first amplifier 401 may be a drain voltage (VDD) terminal. The fourth port of the first amplifier 401 may be grounded. The first amplifier 501 may be referred to as a carrier amplifier.

The second amplifier 402 may be electrically connected to the control circuit 200, the fourth coil 304, the first switch 601, and the second transmission line 502. For example, the first port of the second amplifier 402 may be electrically connected to one end of the fourth coil 304. The second port of the second amplifier 402 may be electrically connected to the first port of the first switch 601 and one end of the second transmission line 502. The third port of the second amplifier 402 may be a drain voltage (VDD) terminal. The fourth port of the second amplifier 402 may be grounded. The fifth port of the second amplifier 402 may be electrically connected to the second port of the control circuit 200. The second amplifier 402 may be referred to as a peaking amplifier.

The first transmission line 501 may be electrically connected to the first amplifier 401, the second transmission line 502, and the resistor 700. For example, one end of the first transmission line 501 may be electrically connected to the second port of the first amplifier 401. The other end of the first transmission line 501 may be electrically connected to the other end of the second transmission line 502 and one end of the resistor 700. The first transmission line 501 may be referred to as TLc.

The second transmission line 502 may be electrically connected to the second amplifier 402, the first switch 601, the first transmission line 501, and the resistor 700. For example, one end of the second transmission line 502 may be electrically connected to the second port of the second amplifier 402 and the first port of the first switch 601.

The first switch 601 may be electrically connected to the second amplifier 402 and the second transmission line 502. For example, the first port of the first switch 601 may be electrically connected to the second port of the second amplifier 402 and one end of the first transmission line 502. The second port of the first switch 601 may be grounded.

The first switch 601 may be connected to the control circuit 200. For example, the third port of the first switch 601 may be electrically connected to the second port of the control circuit 200. The first switch 601 may receive a control signal (Mode cont) from the control circuit 200 through the third port.

The second switch 602 may be electrically connected to the first coil 301 and the third coil 303. For example, the first port of the second switch 602 may be electrically connected to the other end of the first coil 301 and one end of the third coil 303. The second port of the second switch 602 may be grounded.

The second switch 602 may be connected to the control circuit 200. For example, the third port of the second switch 602 may be electrically connected to the second port of the control circuit 200. The second switch 602 may receive a control signal (Mode cont) from the control circuit 200 through the third port.

For example, the first coil 301, the second coil 302, the third coil 303, the fourth coil 304, and the second switch (SW2) 602 may be referred to as a divider. For example, the first transmission line (TLc) 501, the second transmission line (TLp) 502, and the first switch (SW1) 601 may be referred to as a combiner.

The control circuit 200 may control the divider and combiner through the control signal (Mode cont). The control signal (Mode cont) may include a low power mode control signal and a high power mode control signal.

When the low power mode control signal is output from the control circuit 200, the first switch (SW1) and the second switch (SW2) may be turned on. When the first switch (SW1) and the second switch (SW2) are turned on, the first coil 301, the second coil 302, and the second amplifier 401 may be activated, while the third coil 303, the fourth coil 304, and the second amplifier 402 may be deactivated.

When the low power mode control signal is output from the control circuit 200, the first RF input (RF in) signal output from the signal processor 100 may be input to the first amplifier 401 through the first coil 301 and the second coil 302. The first RF input (RF in) signal input to the first amplifier 401 may pass through the first transmission line 501. The first amplifier 401 may perform load impedance modulation on the first RF input (RF in) signal.

When the low power mode control signal is output from the control circuit 200, the third coil 303 and the fourth coil 304 are deactivated, so that the first RF input (RF in) signal output from the signal processor 100 may not be input to the second amplifier 401. Since the first RF input (RF in) signal is not input to the second amplifier 401, it may not pass through the second transmission line 502. Since the first RF input (RF in) signal does not pass through the second transmission line 502, no gain loss may occur in the second transmission line 502.

When the low power mode control signal is output from the control circuit 200, the power consumption of the power amplifier 10 may decrease by the power consumption of the deactivated second amplifier 402. For example, when the power consumption of the first amplifier 401 and the second amplifier 402 is the same or similar, the power consumption of the power amplifier 10 may be reduced by approximately 50 %.

When the high power mode control signal is output from the control circuit 200, the first switch (SW1) and the second switch (SW2) may be turned off. When the first switch (SW1) and the second switch (SW2) are turned off, the first coil 301, the second coil 302, the third coil 303, the fourth coil 304, the first amplifier 401, and the second amplifier 402 may be activated.

When the high power mode control signal is output from the control circuit 200, the first RF input (RF in) signal output from the signal processor 100 may be distributed into a second RF input signal and a third RF input signal.

For example, the second RF input signal may be input to the first amplifier 401 through the first coil 301 and the second coil 302. The second RF input (RF in) signal input to the first amplifier 401 may pass through the first transmission line 501.

For example, the third RF input signal may be input to the second amplifier 402 through the third coil 303 and the fourth coil 304. The third RF input (RF in) signal input to the second amplifier 402 may pass through the second transmission line 502.

When the high power mode control signal is output from the control circuit 200, the first transmission line 501 and the second transmission line 502 may operate as a matching network. For example, since the first transmission line 501 and the second transmission line 502 operate as a matching network with the same phase (90°), the power amplifier 10 may not have a phase compensation line. Therefore, the power amplifier 10 may not require a space for a phase compensation line, no gain loss may occur, and the band used may not be limited.

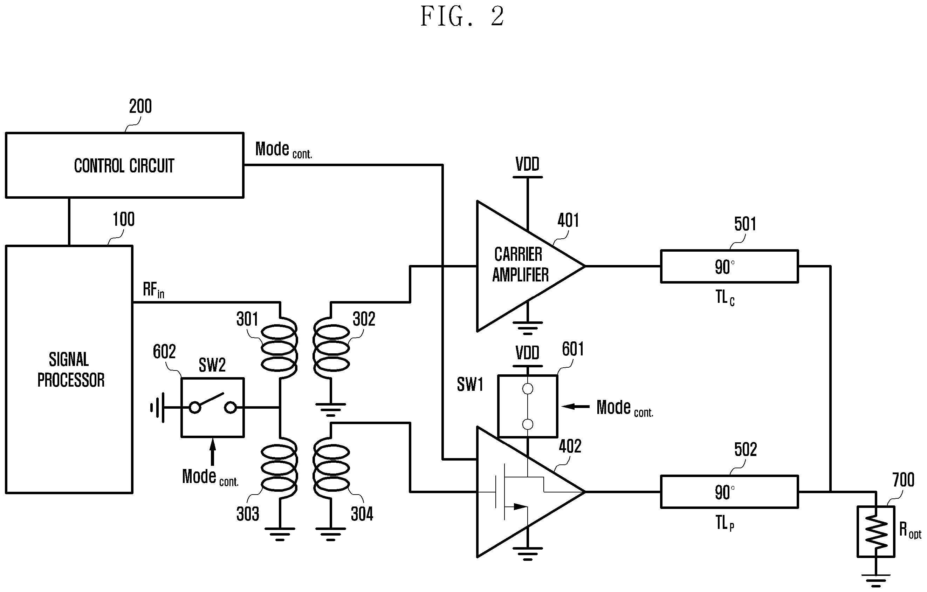

FIG. 2 is a conceptual view illustrating the power amplifier 10 according to another embodiment of the present disclosure.

With reference to FIG. 2, the power amplifier 10 may include a signal processor 100, a control circuit 200, a first coil 301, a second coil 302, a third coil 303, a fourth coil 304, a first amplifier (Carrier Amp) 401, a second amplifier (Peaking Amp) 402, a first transmission line (TLc) 501, a second transmission line (TLp) 502, a first switch (SW1) 601, a second switch (SW2) 602, and a resistor (Ropt) 700.

For example, in the power amplifier 10 according to another embodiment, the arrangement structure of the signal processor 100, the control circuit 200, the first coil 301, the second coil 302, the third coil 303, the fourth coil 304, the first amplifier (Carrier Amp) 401, the second amplifier (Peaking Amp) 402, the first transmission line (TLc) 501, the second transmission line (TLp) 502, the first switch (SW1) 601, and the resistor (Ropt) 700 may be the same as the arrangement structure of the power amplifier 10 according to the embodiment of FIG. 1.

The arrangement structure of the second switch (SW2) 602 according to another embodiment may differ from the arrangement structure of the power amplifier 10 according to the embodiment of FIG. 1. For example, the first port of the second switch (SW2) 602 may be electrically connected to the fourth port of the second amplifier 402. The second port of the second switch (SW2) 602 may be a drain terminal.

For example, the first coil 301, the second coil 302, the third coil 303, the fourth coil 304, and the second switch (SW2) 602 may be referred to as a divider (divider). For example, the second amplifier 402, the first transmission line (TLc) 501, the second transmission line (TLp) 502, and the first switch (SW1) 601 may be referred to as a combiner (combiner).

The control circuit 200 may control the divider and combiner through the control signal (Mode cont). The control signal (Mode cont) may include a low power mode control signal and a high power mode control signal.

When the low power mode control signal is output from the control circuit 200, the first switch (SW1) may be turned on, and the second switch (SW2) may be turned off. When the low power mode control signal is output from the control circuit 200, the first coil 301, the second coil 302, and the first amplifier 401 may be activated, while the third coil 303, the fourth coil 304, and the second amplifier 402 may be deactivated.

When the low power mode control signal is output from the control circuit 200, the first RF input (RF in) signal output from the signal processor 100 may be input to the first amplifier 401 through the first coil 301 and the second coil 302. The first RF input (RF in) signal input to the first amplifier 401 may pass through the first transmission line 501. The first amplifier 401 may perform load impedance modulation on the first RF input (RF in) signal.

When the low power mode control signal is output from the control circuit 200, the third coil 303 and the fourth coil 304 are deactivated, so that the first RF input (RF in) signal output from the signal processor 100 may not be input to the second amplifier 401. Since the first RF input (RF in) signal is not input to the second amplifier 401, it may not pass through the second transmission line 502. Since the first RF input (RF in) signal does not pass through the second transmission line 502, no gain loss may occur in the second transmission line 502.

When the low power mode control signal is output from the control circuit 200, the power consumption of the power amplifier 10 may decrease by the power consumption of the deactivated second amplifier 402. For example, when the power consumption of the first amplifier 401 and the second amplifier 402 is the same or similar, the power consumption of the power amplifier 10 may be reduced by approximately 50%.

When the high power mode control signal is output from the control circuit 200, the first switch (SW1) may be turned off, and the second switch (SW2) may be turned on. When the first switch (SW1) is turned off and the second switch (SW2) is turned on, the first coil 301, the second coil 302, the third coil 303, the fourth coil 304, the first amplifier 401, and the second amplifier 402 may be activated.

When the high power mode control signal is output from the control circuit 200, a first RF input (RF in) signal output from the signal processor 100 may be distributed into a second RF input signal and a third RF input signal.

For example, the second RF input signal may be input to the first amplifier 401 through the first coil 301 and the second coil 302. The second RF input (RF in) signal input to the first amplifier 401 may pass through the first transmission line 501.

For example, the third RF input signal may be input to the second amplifier 402 through the third coil 303 and the fourth coil 304. The third RF input (RF in) signal input to the second amplifier 402 may pass through the second transmission line 502.

When the high power mode control signal is output from the control circuit 200, the first transmission line 501 and the second transmission line 502 may operate as a matching network. For example, since the first transmission line 501 and the second transmission line 502 operate as a matching network with the same phase (90°), the power amplifier 10 may not have a phase compensation line. Therefore, the power amplifier 10 may not require a space for a phase compensation line, no gain loss may occur, and the band used may not be limited.

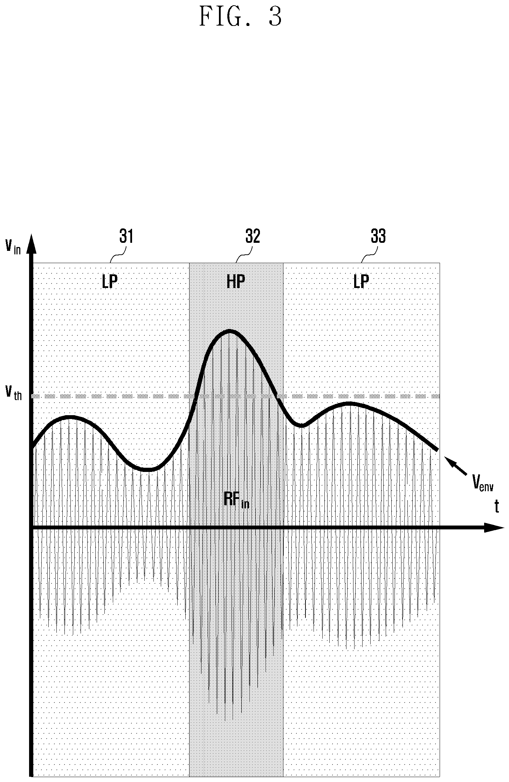

FIG. 3 is a graph illustrating the relationship between a RF input (RF in) signal and an input voltage (Vin) according to a low power mode control signal and a high power mode control signal of the power amplifier 10 according to the present disclosure.

With reference to FIG. 3, a low power mode (LP) 31 or 33 and a high power mode (HP) of the power amplifier 10 may be determined according to a threshold voltage (Vth) based on the input voltage (Vin). When the low power mode control signal is output from the control circuit 200, the power consumption 31 or 33 of the power amplifier 10 may decrease by the power consumption of the deactivated second amplifier 402. For example, when the power consumption of the first amplifier 401 and the second amplifier 402 is the same or similar, the power consumption 31 or 33 of the power amplifier 10 may be reduced by approximately 50 %.

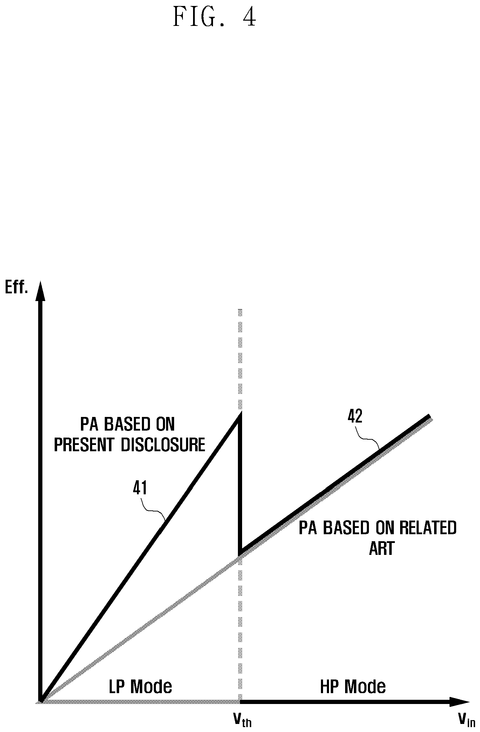

FIG. 4 is a graph illustrating the relationship between the input voltage (Vin) and efficiency according to the low power mode and high power mode of the power amplifier 10 according to the present disclosure.

With reference to FIG. 4, it can be seen that the efficiency 41 of the power amplifier 10 according to the present disclosure, based on the input voltage (Vin), is superior to the efficiency 42 of a power amplifier according to the related art in the low power mode.

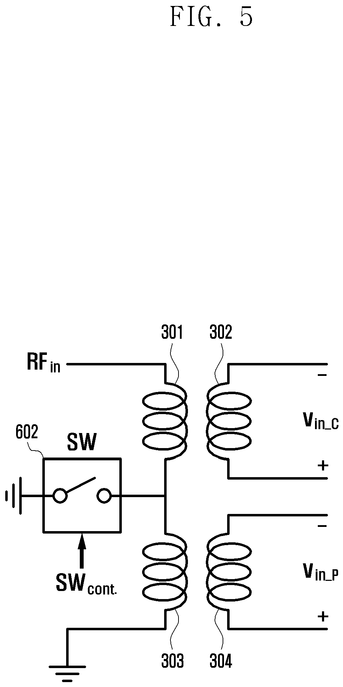

FIG. 5 is a conceptual view illustrating a divider of the power amplifier 10 according to the present disclosure.

With reference to FIG. 5, the divider (divider) including the first coil 301, the second coil 302, the third coil 303, the fourth coil 304, and the second switch (SW2) 602 may output a RF input (RF in) power signal output from the signal processor 100 according to the control signal output from the control circuit 200.

For example, the second switch (SW2) may receive the low power mode control signal from the control circuit 200. The second switch (SW2) may be turned on based on the low power mode control signal. When the second switch (SW2) is turned on, the first coil 301, the second coil 302, and the second amplifier 401 may be activated, while the third coil 303, the fourth coil 304, and the second amplifier 402 may be deactivated. When the second switch (SW2) is turned on, the first RF input (RF in) signal output from the signal processor 100 may be input to the first amplifier 401 through the first coil 301 and the second coil 302. For example, a voltage (Vin_C) across both ends of the second coil 302 may be -0dB.

For example, the second switch (SW2) may receive the high power mode control signal from the control circuit 200. The second switch (SW2) may be turned off based on the high power mode control signal. When the second switch (SW2) is turned off, the first coil 301, the second coil 302, the third coil 303, the fourth coil 304, the first amplifier 401, and the second amplifier 402 may be activated. When the second switch (SW2) is turned off, the first RF input (RF in) signal output from the signal processor 100 may be distributed into the second RF input signal and the third RF input signal. For example, the second RF input signal may be input to the first amplifier 401 through the first coil 301 and the second coil 302. The third RF input signal may be input to the second amplifier 402 through the third coil 303 and the fourth coil 304. For example, a voltage (Vin_C) across both ends of the second coil 302 may be -3dB. A voltage (Vin_P) across both ends of the fourth coil 304 may be -3dB.

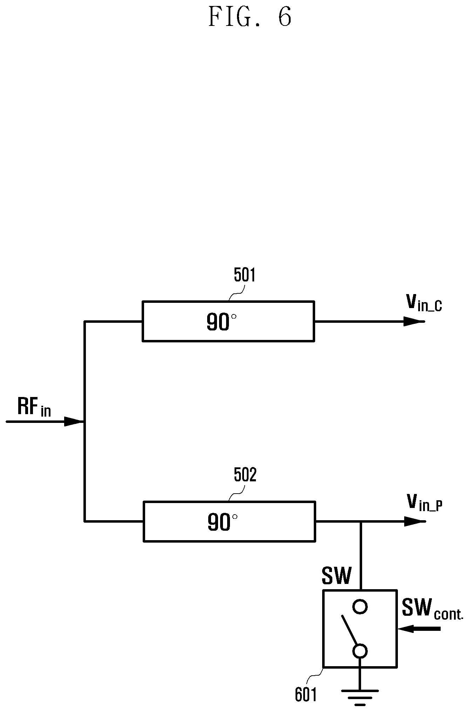

FIG. 6 is a conceptual view illustrating a divider of the power amplifier 10 according to another embodiment of the present disclosure.

With reference to FIG. 6, the divider according to another embodiment of the present disclosure may include the first transmission line (TLc) 501, the second transmission line (TLp) 502, and the first switch (SW1) 601.

The first switch (SW1) 601 may receive the low power mode control signal from the control circuit 200. The first switch (SW1) 601 may be turned on based on the low power mode control signal. When the first switch (SW1) 601 is turned on, the first transmission line 501 may be activated, and the second transmission line 502 may be deactivated. When the second switch (SW2) is turned on, the first RF input (RF in) signal output from the first amplifier 401 may be input to the first transmission line 501.

The second switch (SW2) 602 may receive the high power mode control signal from the control circuit 200. The second switch (SW2) 602 may be turned off based on the high power mode control signal. When the second switch (SW2) 602 is turned off, the first transmission line 501 and the second transmission line 502 may be activated. When the second switch (SW2) 602 is turned off, the second RF input (RF in) signal output from the first amplifier 401 may be input to the first transmission line 501. When the second switch (SW2) 602 is turned off, the third RF input (RF in) signal output from the second amplifier 402 may be input to the second transmission line 502.

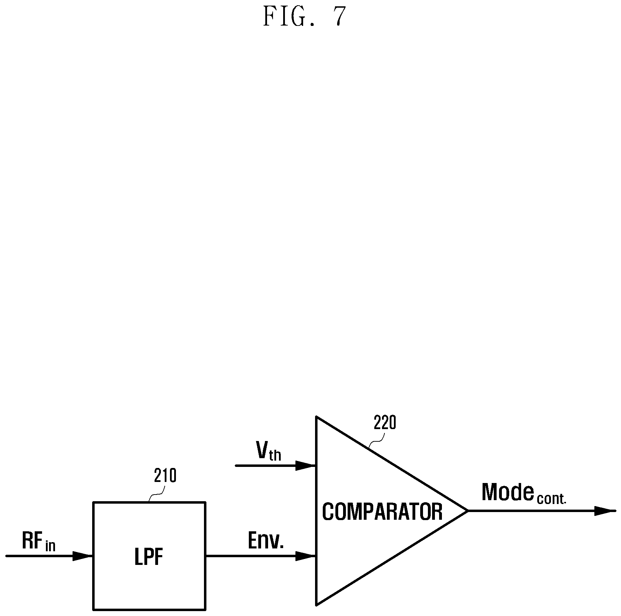

FIG. 7 is a conceptual view illustrating a control circuit 200 of the power amplifier 10 according to the present disclosure.

With reference to FIG. 7, the control circuit 200 may include a low power filter (LPF) 210 and a comparator 220.

For example, one end of the low power filter (LPF) 210 may be electrically connected to one end of the signal processor 100. The other end of the low power filter (LPF) 210 may be electrically connected to the first port of the comparator 220.

The first port of the comparator 220 may be electrically connected to the other end of the low power filter (LPF) 210. The second port of the comparator 220 may be electrically connected to the fourth port of the second amplifier 402, the third port of the first switch 601, and the third port of the second switch 602. The third port of the comparator 220 may be electrically connected to one end of the signal processor 100.

The low power filter (LPF) 210 may receive the first RF input (RF in) signal from the signal processor 100. The low power filter (LPF) 210 may generate an envelope signal based on the first RF input (RF in) signal. The low power filter (LPF) 210 may output the envelope signal to the comparator 220.

The comparator 220 may receive the envelope signal from the low power filter (LPF) 210 through the first port. The comparator 220 may receive a mode threshold value (Vth) from the signal processor 100 through the third port. For example, the signal processor 100 may determine the low power mode and high power mode. The signal processor 100 may determine the mode threshold value based on the low power mode or high power mode. The mode threshold value may be a value that serves as a reference for generating the low power mode control signal or high power mode signal. The comparator 220 may generate the low power mode control signal or high power mode signal based on the envelope signal and the mode threshold value. The comparator 220 may output the control signal through the second port.

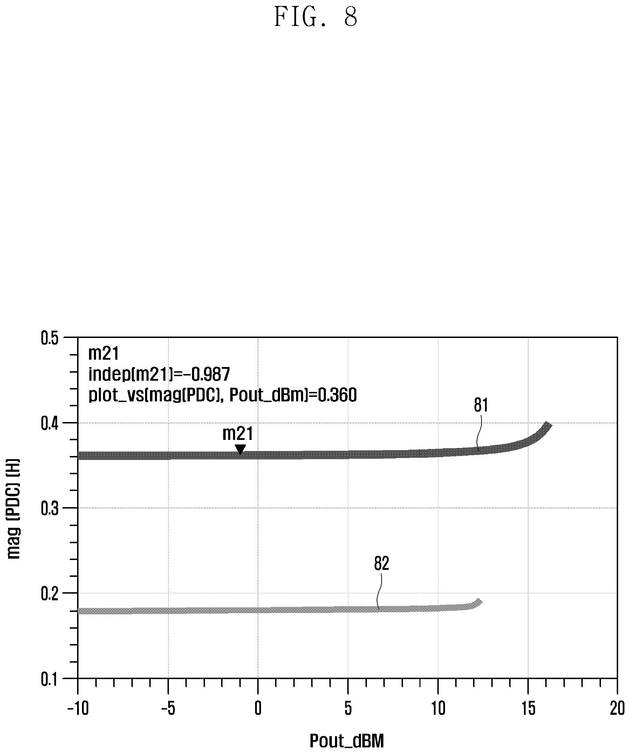

FIG. 8 is a graph illustrating the power dissipation according to the low power mode and high power mode of the power amplifier 10 according to the present disclosure.

With reference to FIG. 8, a graph 81 of output AC power (Pout) (dBm) versus total supplied DC power (PDC) (H) in high power mode, and a graph 82 of output AC power (Pout) (dBm) versus total supplied DC power (PDC) (H) in low power mode are shown for the power amplifier 10 according to the present disclosure. Here, it is assumed that the power amplifier 10 has a power consumption of 180 mW in the low power mode and 360 mW in the high power mode, but this is not limited thereto.

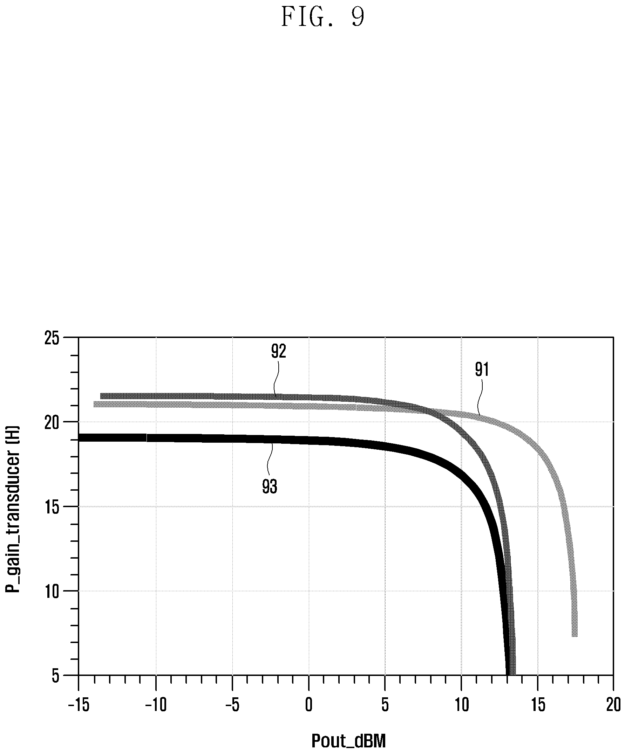

FIG. 9 is a graph illustrating a gain according to the low power mode and high power mode of the power amplifier 10 according to the present disclosure.

With reference to FIG. 9, a graph 91 of gain (H) versus output AC power (Pout) (dBm) in the high power mode, a graph 92 of gain (H) versus output AC power (Pout) (dBm) in the low power mode for the power amplifier 10 according to the present disclosure, and a graph 93 of gain (H) versus output AC power (Pout) (dBm) for the power amplifier according to the related art are shown.

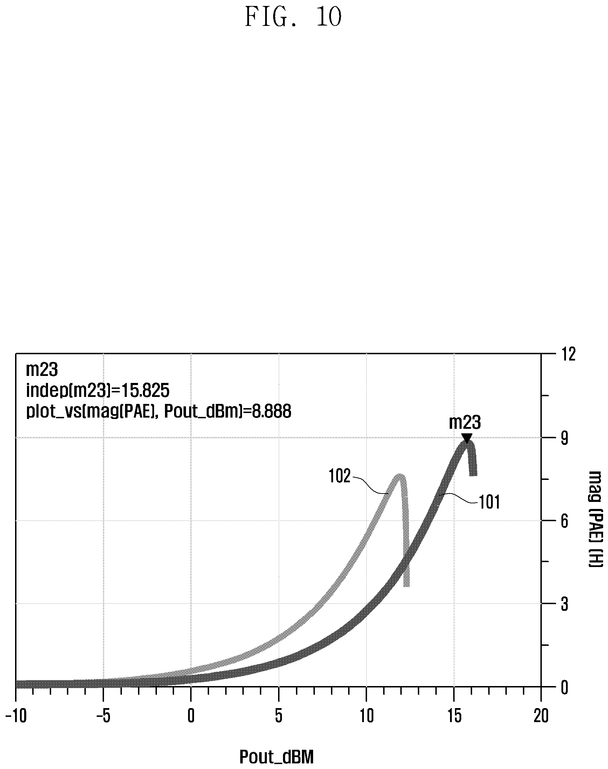

FIG. 10 is a graph illustrating power added efficiency (PAE) according to the low power mode and high power mode of the power amplifier 10 according to the present disclosure.

With reference to FIG. 10, a graph 101 of power added efficiency (PAE) (H) versus output power (Pout) (dBm) in the high power mode, and a graph 102 of power added efficiency (PAE) (H) versus output power (Pout) (dBm) in the low power mode for the power amplifier 10 according to the present disclosure are shown.

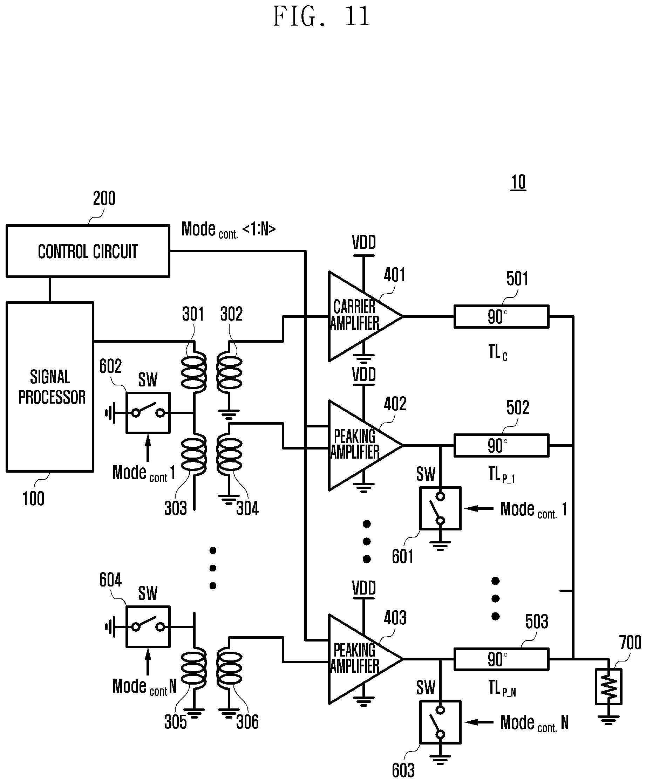

FIG. 11 is a conceptual view illustrating the power amplifier 10 according to yet another embodiment of the present disclosure.

With reference to FIG. 11, the power amplifier 10 may include a signal processor 100, a control circuit 200, a first coil 301, a second coil 302, a third coil 303, a fourth coil 304, a first amplifier (Carrier Amp) 401, a second amplifier (Peaking Amp) 402, a first transmission line (TLc) 501, a second transmission line (TLp) 502, a first switch (SW1) 601, a second switch (SW2) 602, and a resistor (Ropt) 700.

The power amplifier 10 according to another embodiment of the present disclosure may further include 2n coils, n amplifiers, n transmission lines, and 2n switches. For example, the power amplifier 10 may further include a 2n-1-th coil 305, a 2n-th coil 306, an n-th amplifier 403, a n-th transmission line 503, a 2n-1-th switch 603, and a 2n-th switch 604.

The 2n-1-th coil 305 may be electrically connected to the third coil 303 and the 2n-th switch 604. For example, one end of the 2n-1-th coil 305 may be electrically connected to the third coil 303 and the first port of the 2n-th switch 604. The other end of the 2n-1-th coil 305 may be grounded.

The 2n-th coil 306 may be electrically connected to the n-th amplifier 403. For example, one end of the 2n-th coil 306 may be electrically connected to the first port of the n-th amplifier 403. The other end of the 2n-th coil 306 may be grounded.

The n-th amplifier 403 may be electrically connected to the control circuit 200, the 2n-th coil 306, the n-th transmission line 503, and the 2n-1-th switch 603. For example, the first port of the n-th amplifier 403 may be electrically connected to one end of the 2n-th coil 306. The second port of the n-th amplifier 403 may be electrically connected to one end of the n-th transmission line 503 and the first port of the 2n-1-th switch 603. The third port of the n-th amplifier 403 may be a drain terminal. The fourth port of the n-th amplifier 403 may be grounded. The fifth port of the n-th amplifier 403 may be electrically connected to the second port of the control circuit 200.

The n-th transmission line 503 may be electrically connected to the n-th amplifier 403, the 2n-1-th switch 603, and the resistor (Ropt) 700. For example, one end of the n-th transmission line 503 may be electrically connected to the second port of the n-th amplifier 403 and the first port of the 2n-1-th switch 603. The other end of the n-th transmission line 503 may be electrically connected to one end of the resistor (Ropt) 700.

The 2n-1-th switch 603 may be electrically connected to the n-th amplifier 403 and the n-th transmission line 503. For example, the first port of the 2n-1-th switch 603 may be electrically connected to the second port of the n-th amplifier 403 and one end of the n-th transmission line 503. The second port of the 2n-1-th switch 603 may be grounded. The third port of the 2n-1-th switch 603 may be electrically connected to the second port of the control circuit 200. The 2n-1-th switch 603 may receive the control signal (Mode cont) output from the control circuit 200 through the third port.

The 2n-th switch 604 may be electrically connected to the 2n-1-th coil 305. For example, one end of the 2n-th switch 604 may be electrically connected to one end of the 2n-1-th coil 305. The other end of the 2n-th switch 604 may be grounded.

The resistor (Ropt) 700 may be electrically connected to the n-th transmission line 503. For example, one end of the resistor 700 may be electrically connected to the other end of the n-th transmission line 503. The other end of the resistor 700 may be grounded.

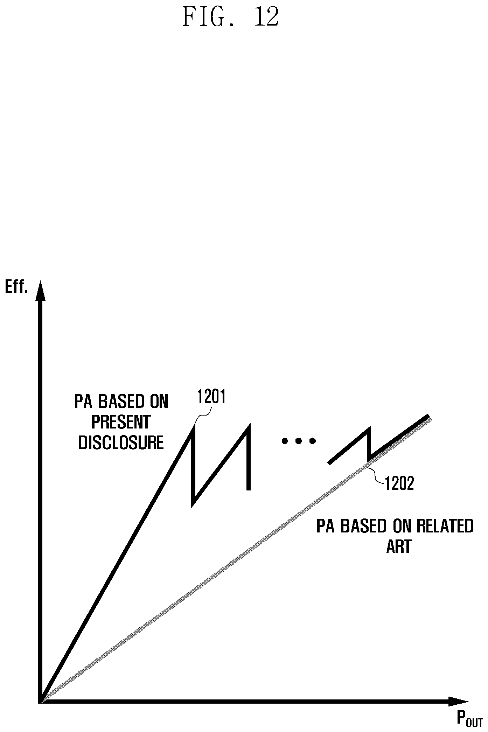

FIG. 12 is a graph illustrating the relationship between the input voltage (Vin) and efficiency according to the low power mode and high power mode of the power amplifier 10 according to yet another embodiment of the present disclosure.

With reference to FIG. 12, it can be seen that the efficiency 1201 of the power amplifier 10 according to the present disclosure, based on the input voltage (Vin), is superior to the efficiency 1202 of a power amplifier according to the related art in the low power mode.

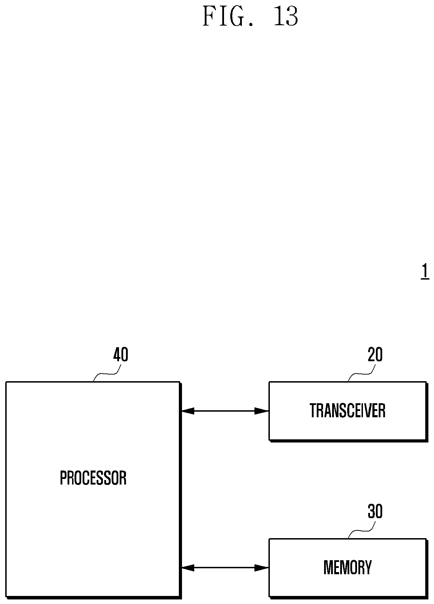

FIG. 13 is a block diagram illustrating an electronic device 1 including the power amplifier 10 according to the present disclosure.

With reference to FIG. 13, the electronic device 1 according to the present disclosure may include a transceiver 20, a memory 30, and a processor 40. The processor 40, transceiver 20, and memory 30 of the electronic device 1 may operate according to the operating method of the electronic device 1. The constituent elements of the electronic device 1 are not limited to those illustrated in FIG. 13. For example, the electronic device 1 may include more constituent elements or fewer constituent elements than those in FIG. 13. In addition, the processor 40, transceiver 20, and memory 30 may be implemented in the form of a single chip.

The transceiver 20 refers to the receiving and transmitting parts of the electronic device 1 and may transmit and receive signals with a base station or a network entity. The signals transmitted and received with the base station may include control information and data. To this end, the transceiver 20 may include an RF transmitter that performs up-conversion and amplification on a frequency of a signal to be transmitted, and an RF receiver that performs low-noise amplification on a received signal and performs down-conversion on a frequency of the received signal. However, this is just an embodiment of the transceiver 20, and the constituent elements of the transceiver 20 are not limited to the RF transmitter and RF receiver. For example, the transceiver 20 may include the power amplifier 10 according to the present disclosure.

Additionally, the transceiver 20 may include both wired and wireless transceivers, and may include various configurations for transmitting and receiving signals.

In addition, the transceiver 20 may receive a signal through a radio channel, output the received signal to the processor 40, and transmit an output signal of the processor 40 through the radio channel.

Additionally, the transceiver 20 may receive communication signals and output them to the processor, and transmit the signals output from the processor to a network entity through a wired or wireless network.

The memory 30 may store programs and data required for the operation of the electronic device 1. Additionally, the memory 30 may store control information or data included in the signals acquired by the electronic device 1. The memory 30 may be configured of a storage medium, such as ROM, RAM, a hard disk, a CD-ROM, and a DVD, or a combination of storage media.

The processor 40 may control a series of processes to enable the electronic device 10 to operate according to the embodiments of the present disclosure, as described above. The processor 40 may include at least one processor. For example, the processor 40 may include a communication processor (CP) that performs control for communications and an application processor (AP) that controls an upper layer such as an application program.

The electronic device 1 according to the present disclosure may be at least one of various types of communication nodes. For example, the electronic device 1 may be at least one of a terminal, a base station, or any of the various network entities used in various communication systems.

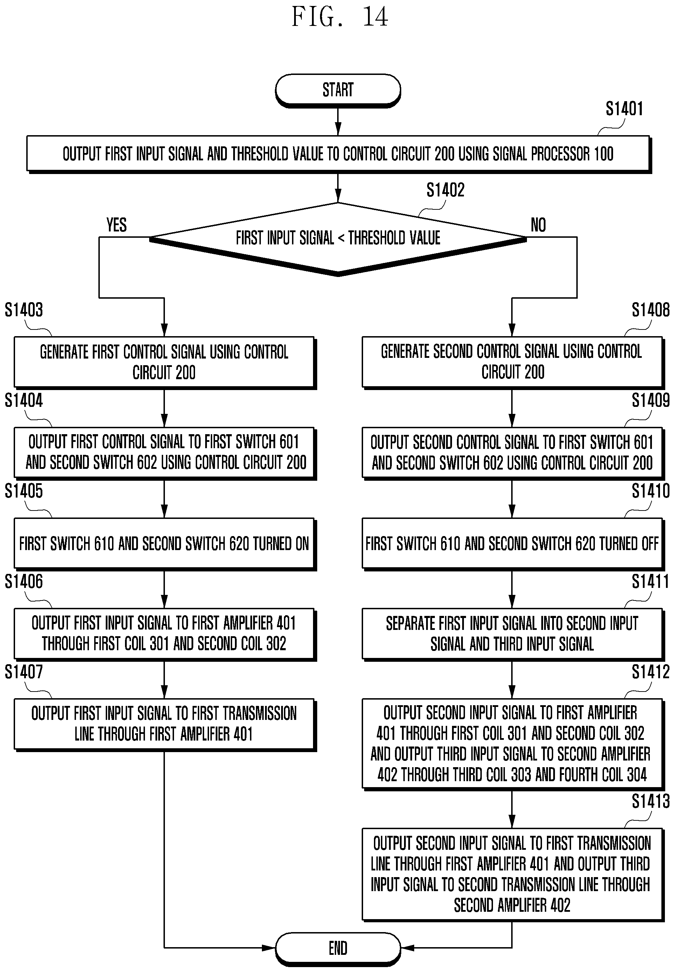

FIG. 14 is a flowchart illustrating the operation sequence of the power amplifier 10 or the electronic device 1 including the power amplifier 10 according to an embodiment of the present disclosure.

With reference to FIG. 14, in step S1401, the power amplifier 10 or the electronic device 1 including the power amplifier 10 may output the first input signal and the threshold signal to the control circuit 200 using the signal processor 100. The first input signal may be referred to as the first RF input signal (RF in).

In step S 1402, the power amplifier 10 or the electronic device 1 including the power amplifier 10 may use the control circuit 200 to determine whether the first input signal is less than the threshold value. For example, the low power filter (LPF) 210 of the control circuit 200 may generate an envelope signal based on the first input signal from the signal processor 100. The low power filter (LPF) 210 may output the envelope signal corresponding to the first input signal to the comparator 220 of the control circuit 200. The comparator 220 may determine whether the envelope signal corresponding to the first input signal is less than the threshold value.

In step S1402, when it is determined that the first input signal is less than the threshold value, the power amplifier 10 or the electronic device 1 including the power amplifier 10 may perform steps S1403 to S1407.

In step S1403, the power amplifier 10 or the electronic device 1 including the power amplifier 10 may generate the first control signal using the control circuit 200. The first control signal may be the low power mode control signal.

In step S1404, the power amplifier 10 or the electronic device 1 including the power amplifier 10 may output the first control signal to the first switch 601 and the second switch 602 using the control circuit 200.

In step S1405, the power amplifier 10 or the electronic device 1 including the power amplifier 10 may turn on the first switch 610 and the second switch 602 based on the first control signal.

In step S1406, the power amplifier 10 or the electronic device 1 including the power amplifier 10 may output the first input signal to the first amplifier 401 through the first coil 301 and the second coil 302.

In step S1407, the power amplifier 10 or the electronic device 1 including the power amplifier 10 may output the first input signal from the first amplifier 401 to the first transmission line 501.

When it is determined in step S1402 that the first input signal exceeds the threshold value, the power amplifier 10 or the electronic device 1 including the power amplifier 10 may perform steps S1408 to S1413.

In step S1408, the power amplifier 10 or the electronic device 1 including the power amplifier 10 may generate the second control signal using the control circuit 200. The second control signal may be the high power mode control signal.

In step S1409, the power amplifier 10 or the electronic device 1 including the power amplifier 10 may output the first control signal to the first switch 601 and the second switch 602 using the control circuit 200.

In step S1410, the power amplifier 10 or the electronic device 1 including the power amplifier 10 may turn off the first switch 610 and the second switch 602 based on the second control signal.

In step S1411, the power amplifier 10 or the electronic device 1 including the power amplifier 10 may separate the first input signal into the second input signal and the third input signal.

In step S1412, the power amplifier 10 or the electronic device 1 including the power amplifier 10 may output the second input signal to the first amplifier 401 through the first coil 301 and the second coil 302, and output the third input signal to the second amplifier 402 through the third coil 303 and the fourth coil 304.

In step S1413, the power amplifier 10 or the electronic device 1 including the power amplifier 10 may output the second input signal to the first transmission line 501 through the first amplifier 401, and output the third input signal to the second transmission line 502 through the second amplifier 402 .

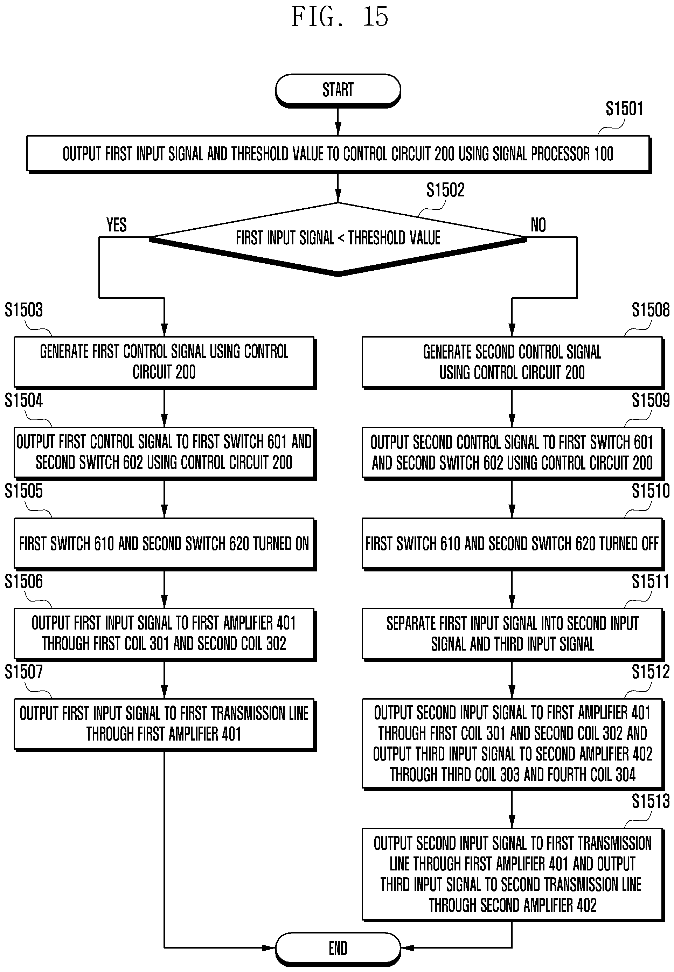

FIG. 15 is a flowchart illustrating the operation sequence of the power amplifier 10 or the electronic device 1 including the power amplifier 10 according to another embodiment of the present disclosure.

With reference to FIG. 15, in step S1501, the power amplifier 10 or the electronic device 1 including the power amplifier 10 may output the first input signal and the threshold value signal to the control circuit 200 using the signal processor 100. The first input signal may be referred to as the first RF input signal (RF in).

In step S1502, the power amplifier 10 or the electronic device 1 including the power amplifier 10 may use the control circuit 200 to determine whether the first input signal is less than the threshold value. For example, the low power filter (LPF) 210 of the control circuit 200 may generate an envelope signal based on the first input signal from the signal processor 100. The low power filter (LPF) 210 may output the envelope signal corresponding to the first input signal to the comparator 220 of the control circuit 200. The comparator 220 may determine whether the envelope signal corresponding to the first input signal is less than the threshold value.

In step S1502, when it is determined that the first input signal is less than the threshold value, the power amplifier 10 or the electronic device 1 including the power amplifier 10 may perform steps S1503 to S1507.

In step S1503, the power amplifier 10 or the electronic device 1 including the power amplifier 10 may generate the first control signal using the control circuit 200. The first control signal may be the low power mode control signal.

In step S1504, the power amplifier 10 or the electronic device 1 including the power amplifier 10 may output the first control signal to the first switch 601 and the second switch 602 using the control circuit 200.

In step S1505, the power amplifier 10 or the electronic device 1 including the power amplifier 10 may turn off the first switch 610 and turn on the second switch 602.

In step S1506, the power amplifier 10 or the electronic device 1 including the power amplifier 10 may output the first input signal to the first amplifier 401 through the first coil 301 and the second coil 302.

In step S1507, the power amplifier 10 or the electronic device 1 including the power amplifier 10 may output the first input signal from the first amplifier 401 to the first transmission line 501.

The power amplifier 10 or the electronic device 1 including the power amplifier 10 may perform steps S1508 to S1513 when it is determined in step S1502 that the first input signal exceeds the threshold value. In step S1508, the power amplifier 10 or the electronic device 1 including the power amplifier 10 may generate the second control signal using the control circuit 200. The second control signal may be the high power mode control signal.

In step S1509, the power amplifier 10 or the electronic device 1 including the power amplifier 10 may output the first control signal to the first switch 601 and the second switch 602 using the control circuit 200.

In step S1510, the power amplifier 10 or the electronic device 1 including the power amplifier 10 may turn on the first switch 610 and turn off the second switch 602.

In step S1511, the power amplifier 10 or the electronic device 1 including the power amplifier 10 may separate the first input signal into the second input signal and the third input signal.

In step S1512, the power amplifier 10 or the electronic device 1 including the power amplifier 10 may output the second input signal to the first amplifier 401 through the first coil 301 and the second coil 302, and output the third input signal to the second amplifier 402 through the third coil 303 and the fourth coil 304.

In step S1513, the power amplifier 10 or the electronic device 1 including the power amplifier 10 may output the second input signal to the first transmission line 501 through the first amplifier 401, and output the third input signal to the second transmission line 502 through the second amplifier 402 .

### [Industrial Applicability]

The present disclosure may be used in the electronics industry and the information and communication industry.

## Claims

1. A power amplifier comprising:
a signal processor;
a control circuit electrically connected to the signal processor;
a divider electrically connected to the signal processor and the control circuit;
a first amplifier electrically connected to the divider;
a second amplifier electrically connected to the control circuit and the divider; and
a combiner electrically connected to the control circuit, the first amplifier, and the second amplifier.

2. The power amplifier of claim 1, wherein the signal processor outputs a first input signal and a threshold signal to the control circuit, and the control circuit generates a first control signal or a second control signal based on the first input signal and the threshold signal.

3. The power amplifier of claim 2, wherein the signal processor outputs the first input signal to the divider, the control circuit outputs the first control signal to the divider, and the divider outputs the first input signal to the first amplifier based on the first control signal.

4. The power amplifier of claim 3, wherein the first power amplifier outputs the first input signal received from the divider to the combiner.

5. The power amplifier of claim 2, wherein the signal processor outputs the first input signal to the divider, the control circuit outputs the second control signal to the divider, and the divider separates the first input signal into a second input signal and a third input signal based on the second control signal, and wherein the divider outputs the second input signal to the first amplifier, and the divider outputs the third input signal to the second amplifier.

6. The power amplifier of claim 5, wherein the first power amplifier outputs the second input signal received from the divider to the combiner, and the second power amplifier outputs the third input signal received from the divider to the combiner.

7. The power amplifier of claim 1, wherein the combiner includes a first transmission line, a second transmission line, and a first switch, and
wherein the first transmission line is electrically connected to the first amplifier and the second transmission line is electrically connected to the second amplifier.

8. The power amplifier of claim 7, wherein the first switch is electrically connected to the second amplifier and the second transmission line.

9. The power amplifier of claim 7, wherein the first switch is electrically connected to the second amplifier.

10. The power amplifier of claim 1, wherein the divider includes:
a first coil;
a second coil electromagnetically coupled to the first coil;
a third coil electrically connected to the first coil;
a fourth coil electromagnetically coupled to the third coil; and
a second switch electrically connected to the first coil and the third coil,
wherein the second switch is turned on or off based on a control signal output from the control signal, and
wherein the divider, based on the second switch being turned on or off, outputs the first input signal received from the signal processor to the first amplifier, or separates the first input signal into a second input signal and a third input signal to output the second input signal to the first amplifier and output the third input signal to the second amplifier.

11. An electronic device comprising:
a transceiver including a power amplifier;
a controller configured to control the transceiver; and
a memory including instructions executed by the controller,
wherein the power amplifier includes:
a signal processor;
a control circuit electrically connected to the signal processor;
a divider electrically connected to the signal processor and the control circuit;
a first amplifier electrically connected to the divider;
a second amplifier electrically connected to the control circuit and the divider; and
a combiner electrically connected to the control circuit, the first amplifier, and the second amplifier.

12. The electronic device of claim 11, wherein the signal processor outputs a first input signal and a threshold signal to the control circuit, and the control circuit generates a first control signal or a second control signal based on the first input signal and the threshold signal.

13. The electronic device of claim 12, wherein the signal processor outputs the first input signal to the divider, the control circuit outputs the first control signal to the divider, and the divider outputs the first input signal to the first amplifier based on the first control signal.

14. The electronic device of claim 13, wherein the first power amplifier outputs the first input signal received from the divider to the combiner.

15. The electronic device of claim 12, wherein the signal processor outputs the first input signal to the divider, the control circuit outputs the second control signal to the divider, and the divider separates the first input signal into a second input signal and a third input signal based on the second control signal, and
wherein the divider outputs the second input signal to the first amplifier, and the divider outputs the third input signal to the second amplifier.
